# EUROPEAN PATENT SPECIFICATION

(11) **EP 0 378 164 B1**
(45) Date of publication and mention of the grant of the patent: **19.03.1997**
(21) Application number: 90100363.2
(22) Date of filing: 09.01.1990
(51) Int. Cl.: H01L 29/08, H01L 29/732

(54) **Bipolar transistor and method of manufacturing the same**
Bipolarer Transistor und Verfahren zu dessen Herstellung
Transistor bipolaire et méthode pour sa fabrication

(30) Priority: 09.01.1989 JP 2460/89
(43) Date of publication of application: 18.07.1990
(73) Proprietor: KABUSHIKI KAISHA TOSHIBA, Kawasaki-shi, Kanagawa-ken 210 (JP)
(72) Inventor: Momose, Hisayo, Ota-ku Tokyo-To (JP)
(74) Representative: Lehn, Werner, Dipl.-Ing.

(56) References cited:
- EP-A- 0 241 699
- DE-A- 2 911 726

## Description

### FIELD OF THE INVENTION

This invention relates to a semiconductor device including a bipolar transistor and a method of manufacturing the same.

### BACKGROUND OF THE INVENTION

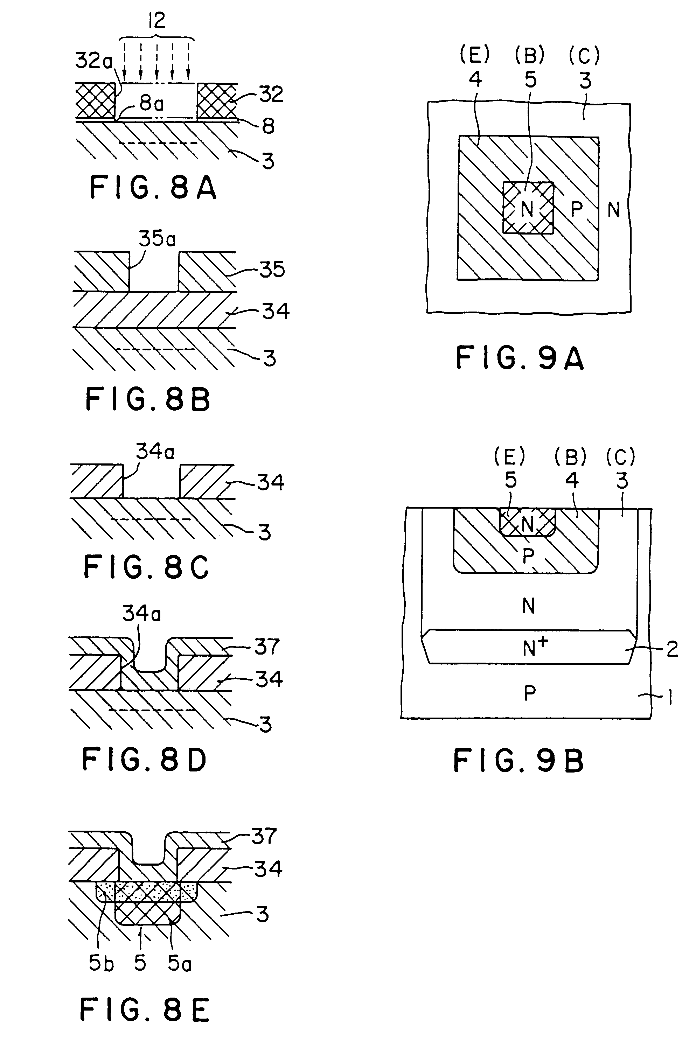

FIGS. 9A and 9B are a plan view and a cross sectional view of an NPN type bipolar transistor (Bi-Tr) as a portion of a conventional semiconductor device, e.g., Bi-CMOS, respectively. This Bi-Tr is manufactured as follows. Namely, an N⁺ type buried layer 2 is formed on a P-type Si substrate 1 and an N-type collector region 3 is grown thereon. A P-type impurity (B or BF₂, etc.) is ion-implanted into a region where the base is to be formed of the collector region 3. Thereafter, using a resist mark, an N-type impurity (e.g., As) is ion-implanted only into a region where the emitter is to be formed in the region where the base is to be formed. Heat treatment is then conducted. As a result, a P-type base region 4 is formed within the N-type collector region 3, and an N-type emitter region 5 is formed within the P-type base region 4. Thus, Bi-Tr is provided.

There are instances where a reverse bias may be applied to the junction portion between the emitter region 5 and the base region 4 of the Bi-Tr. Application of such a reverse bias leads to the difficulty that the emitter-base junction breakdown voltage is lowered and the current gain h_{FE} is also lowered, resulting in considerably deteriorated device characteristics.

A known device is shown in EP-A-0 241 699. It includes an emitter region with a high concentration region and a low concentration region. The high concentration region is surrounded by the low concentration region, but penetrates through the low concentration region to contact a base region.

### SUMMARY OF THE INVENTION

This invention has been made in view of the above, and its object is to provide a semiconductor device constructed so that the device characteristic is not lowered even when a reverse bias is applied to the junction portion between the emitter region and the base region, and a method of manufacturing such a semiconductor device.

According to a first aspect of the present invention, there is provided a semiconductor device as set out in claim 1.

Since such a structure is employed, an electric field at the edge portion of the emitter region is relaxed. Thus, even when a reverse bias is applied to the base-emitter junction portion, there is no possibility that the junction breakdown voltage and the current gain are lowered.
A further aspect of the present invention is set out in claim 6.

In accordance with this invention, even when a reverse bias is applied to the portion across the emitter region and the base region of the bipolar transistor, lowering of the device characteristic can be prevented.

### BRIEF DESCRIPTION OF THE DRAWINGS

In the accompanying drawings:
FIGS. 1A and 1B are a plan view and a cross sectional view of an embodiment according to this invention, respectively;
FIG. 1C is a cross sectional view of other embodiment according to this invention;
FIG. 2 and FIGS. 3A to 3D are cross sectional views showing an example of manufacturing process steps;
FIGS. 4A to 4D, FIG. 5, FIGS 6A to 6E, and FIGS. 7A to 7C, show different examples of manufacturing process steps, respectively without showing all the steps of the invention;
FIGS 8A to 8E show the method of the present invention; and
FIGS. 9A and 9B are a plan view and a cross sectional view of a background art.
FIG. 10 shows the emitter-base junction initial characteristics of the semiconductor devices according to the present invention and the background art.
FIG. 11A shows changes of the emitter-base junction characteristics of the semiconductor devices according to the present invention and the background art after putting the devices into reverse bias stress conditions.
FIG. 11B shows changes of the current gain characteristics of the semiconductor devices according to the present invention and the background art after putting them into reverse bias stress conditions.

### DESCRIPTION OF THE PREFERRED EMBODIMENTS

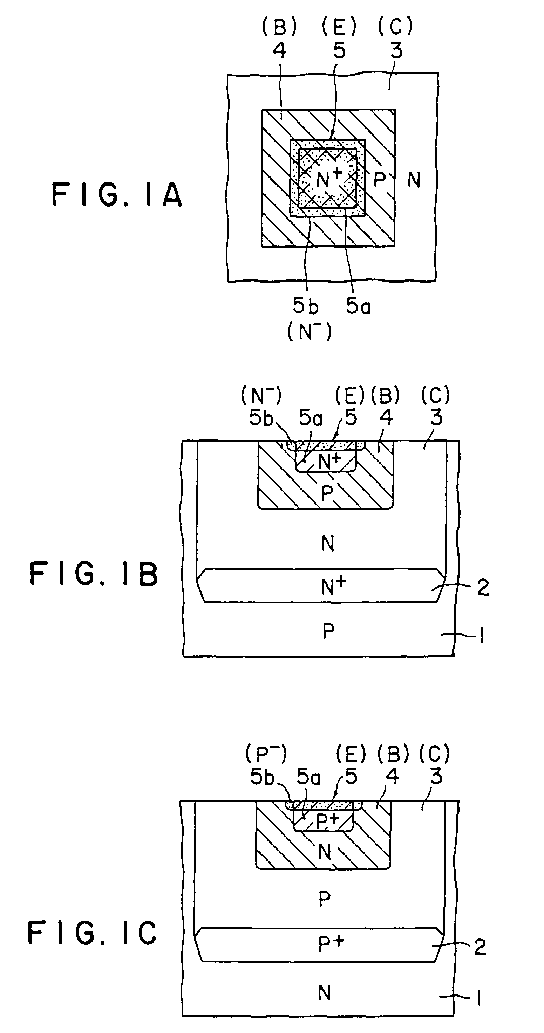

FIGS. 1A and 1B are a plan view and a cross sectional view of an NPN type Bi-Tr of a semiconductor device according to this invention, respectively. In this Bi-Tr, an N-type collector region 3 is formed on the side of the surface of an N⁺ buried layer 2 formed on a P-type semiconductor substrate 1. A P-type base region 4 is formed on the side of the surface of the collector region 3. Furthermore, an N-type emitter region 5 is formed on the side of the surface of the base region 4. This emitter region 5 is composed of two sections. One is a high concentration region (N⁺)5a having a small lateral cross section and a deep depth, and the other is a low concentration region (N⁻)5b having a large lateral cross section and a shallow depth.

In the Bi-Tr of such a structure, an N-type impurity diffused region (5b) having a low concentration is formed at the edge portion of a so-called conventional emitter region (5a) formed by N-type impurity having a high concentration. Thus, an electric field at the edge portion is relaxed. Even when a reverse bias is applied to the junction portion between the base and the emitter, the junction breakdown voltage and the current gain are not lowered. Thus, a high reliability device is provided.

The semiconductor device shown in FIGS. 1A and 1B can be manufactured as follows.

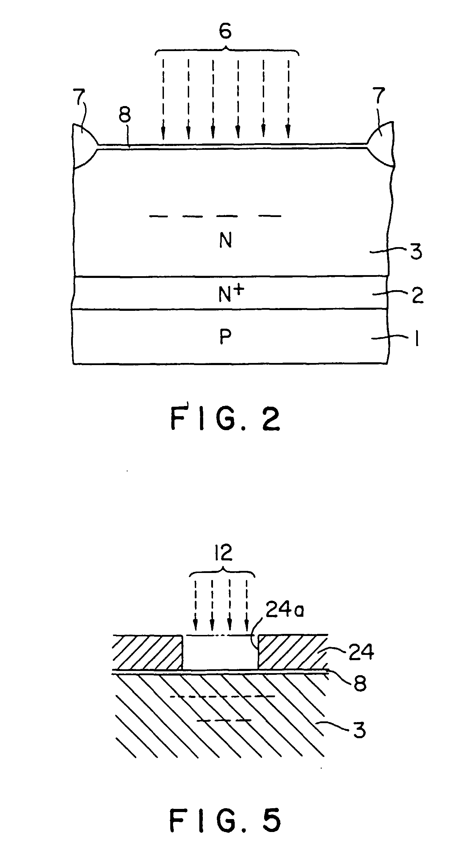

Namely, as shown in FIG. 2, e.g., Sb is ion-implanted into a P-type Si substrate 1 (e.g., 2Ω·cm) under the condition of 100 KeV, 1 x 10¹⁵ cm⁻². A thermal process step under the condition of 1100°C, 60 minutes is implemented. An N⁺ buried layer 2 is thus formed. Thereafter, the surface of the Si substrate 1 is epitaxially grown in the atmosphere including SiH₂Cl₂. An N-type collector region 3 is thus formed. Then, device isolation regions 7, 7 are formed by LOCOS process. Thereafter, a silicon oxide film 8 having a thickness of approximately several ten to several hundred Å is formed by an argon diluted oxidation process. Thereafter, a P-type impurity (e.g., boron or BF₂) 6 is ion-implanted into a region where the base is to be formed under the condition of 25 KeV, 5 x 10¹³ cm⁻².

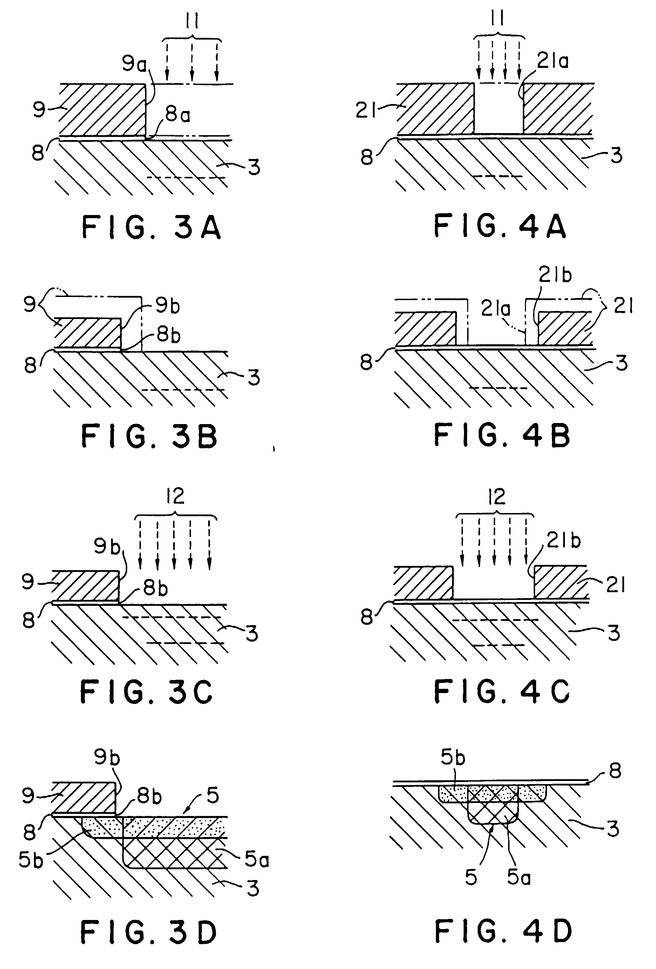

Subsequently, process steps shown in FIGS. 3A to 3D are implemented in succession. These figures show only the surface portion of the substrate shown in FIG. 2. As seen from FIG. 3A, a silicon oxide film 9 is deposited on the oxide film 8 in a manner in close contact therewith by a CVD process so that its thickness is equal to, e.g., 100nm (1000 Å). Then, a resist (not shown) is coated on the silicon oxide film 9 in a manner in close contact therewith. By removing the portion of the resist, above a region where the emitter is to be formed, an opening is provided. Using this resist as a mask, by CDE (Chemical Dry Etching), openings 9a, 8a are provided in the silicon oxide films 9, 8, respectively. Then, that resist is exfoliated. Thus, the state shown in FIG. 3A results. Thereafter, using the silicon oxide films 9, 8 as a mask, an N-type impurity (e.g., As) 11 is densely ion-implanted through the openings 9a, 8a under the condition of 40 KeV, 5 × 10¹⁵ cm⁻² so as to result in the state of high concentration.

Then, as seen from FIG. 3B, the openings 9a, 8a of the silicon oxide films 9, 8 are widened, e.g., by 1000 Å by wet etching process. Thus, larger openings 9b, 8b are newly provided.

Then, as seen from FIG. 3C, an N-type impurity (e.g., P) 12 is sparsely ion-implanted under the condition of 20 KeV, 3 × 10¹³ cm⁻² so as to result in the state of low concentration.

Subsequently, as seen from FIG. 3D, a thermal diffusion process, e.g., a process having a temperature of 900°C and N₂ annealing time of 60 minutes is implemented. Thus, an emitter region 5 including an N-type high concentration region 5a and an N-type low concentration region 5b is formed within the P-type base region 4.

At times subsequent thereto, in the same manner as in widely used semiconductor devices, metallization process and passivation process are implemented in succession. Thus, a semiconductor device is provided.

A semiconductor device according to this invention may be manufactured by various methods described below in addition to the above-described method.

Namely, a first modification will be first described. After undergoing the process shown in FIG. 2, as seen from FIG. 4A, a resist film 21 is coated on the upper surface of the oxide film 8 in a manner in close contact therewith. The portion, above the region where the emitter is to be formed, of the resist film 21 is removed. An opening 21a is thus provided. Then, an N-type (e.g., As) is densely ion-implanted under the condition of 40 KeV, 5 × 10¹⁵ cm⁻² so as to result in a state of high concentration.

Then, as seen from FIG. 4B, the resist film 21 is etched by a wet etching process to further widen the opening 21a by 100nm (1000 Å) to newly form a larger opening 21b.

Then, as seen from FIG. 4C, an N-type impurity (e.g., P) 12 is sparsely ion-implanted under the condition of 20 KeV, 3 × 10¹³ cm⁻² so as to result in the state of low concentration.

Subsequently, as seen from FIG. 4D, the entirety of the resist film 21 is exfoliated. A thermal process similar to the thermal process in FIG. 3D is implemented. Thus, an N-type emitter region 5 including a high concentration region 5a and a low concentration region 5b is formed within the P-type base region 4.

Thereafter, a metallization process and a passivation process are implemented. Thus, a semiconductor device is provided.

A second modified example will now be described.

After the process step in FIG. 2 and the process in FIG. 4A, the entirety of the resist film 21 is exfoliated.

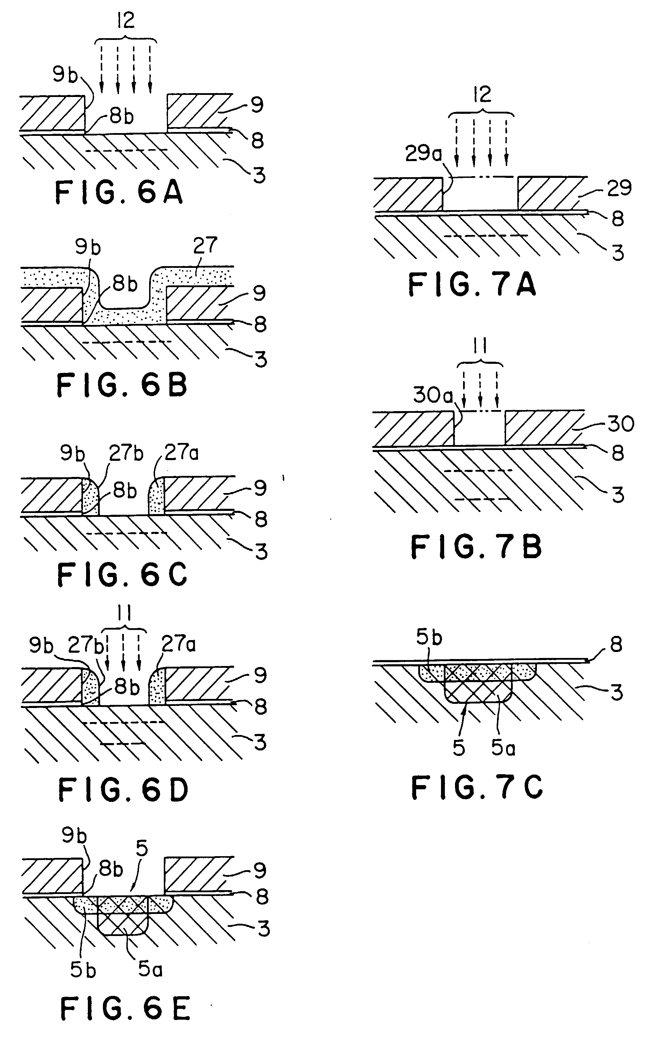

Then, as shown in FIG. 5, a resist film 24 is coated on the oxide film 8. An opening 24a having substantially the same dimension as that of the opening 21b shown in FIG. 4B is provided in the resist film 24. Thereaftrer, an N-type impurity (e.g., P) 12 is sparsely ion-implanted under the condition of 20 KeV, 3 × 10¹³ cm⁻² so as to result in a state of low concentration.

At times subsequent thereto, a semiconductor device is provided by executing the same process as that in FIG. 4D, the metallization process and the passivation process.

A third modified embodiment will now be described.

After the process step in FIG. 2, as seen from FIG. 6A, large openings 8b, 9b are provided in the oxide films 8, 9, respectively, and an N-type impurity 12 is introduced sparsely through these openings 8b, 9b so as to result in a state of low concentration. Thereafter, as seen from FIG. 6B, a polycrystalline silicon oxide film 27 is deposited on the oxide films 8, 9 in a manner in close contact therewith so that its thickness is equal to, e.g., 100nm (1000 Å).

Then, as seen from FIG. 6C, a polycrystalline silicon oxide film 27a is left only within the openings 8b, 9b by anisotropic etching to form an opening 27b. Thereby, an opening 27b is formed.

Then, as seen from FIG. 6D, using the polycrystalline silicon oxide film 27a as a mask, an N-type impurity (e.g., P) 11 is densely ion-implanted under the condition of 40 KeV, 5 × 10¹⁵ cm⁻² so as to result in the state of high concentration.

Then, as seen from FIG. 6E, the remaining polycrystalline silicon oxide film 27a is removed by a dry etching process.

Subsequently, process steps similar to those shown in FIG. 3D, i.e., the thermal process step, the metallization process step, and the passivation process step will be carried out.

In the abovementioned third modified embodiment, a SiO₂ film can be used instead of the polycrystalline silicon film 27. In this case, it is free that the remaining SiO₂ film in the openings 8b, 9b may be either removed or left as it is.

A fourth modified example will now be described.

After the process step shown in FIG. 2, as seen from FIG. 7A, a resist film 29 is coated on the oxide film 8 in a manner in close contact therewith. Only the portion, above the region where the emitter is to be formed, of the resist film 29 is removed to provide a large opening 29a. Thereafter, an N-type impurity (e.g., P) 12 is sparsely ion-implanted through the opening 29a under the condition of 20 KeV, 3 × 10¹³ cm⁻² so as to result in a state of low concentration.

Then, as seen from FIG. 7B, after the entirety of the resist film 29 is exfoliated, a resist film 30 is coated. The portion, above the region where the high concentration region is to be formed, of the resist film 30 is removed to provide a small opening 30a. Thereafter, an N-type impurity (e.g., As) 11 is densely ion-implanted under the condition of 40 KeV, 5 × 10¹⁵ cm⁻² so as to result in a state of high concentration.

Then, as seen from FIG. 7C, the entirety of the resist film 30 is exfoliated. Thereafter, the thermal process, the metallization process and the passivation process are implemented.

Finally, the method according to the present invention will be described.

After the process step shown in FIG. 2, as seen from FIG. 8A, a silicon oxide film 32 is deposited on the oxide film 8 in a manner in close contact therewith by a CVD process so that its thickness is equal to, e.g., 100nm (1000 Å). A resist (not shown) is coated on the oxide film 32 in a manner in close contact therewith. Thereafter, only the portion, above the region where the emitter is to be formed, of the resist is removed to provide an opening.

Then, using this opening as a mask, large openings 32a, 8a are provided in the silicon oxide film 32, 8 by CDE process, respectively. Thereafter, an N-type impurity (e.g., P) 12 is sparsely ion-implanted through these openings 32a, 8a under the condition of 20 KeV, 3 × 10¹³ cm⁻² so as to result in a state of low concentration.

Then, as seen from FIG. 8B, after the oxide films 32, 8 are removed by wet etching process, another oxide film 34 is deposited by a CVD process so that its thickness is equal to 300 nm (3000 Å). Thereafter, a second resist film 35 is coated on the oxide film 34. An exposure process is implemented thereto to form an opening 35a.

Then, as seen from FIG. 8C, an opening 34a is provided in the oxide film 34 by CDE process. Thereafter, the entirety of the resist 35 is exfoliated.

Then, as seen from FIG. 8D, a polycrystalline silicon film 37 including an N-type impurity (e.g., P) is deposited on the silicon oxide film 34 in a manner in contact therewith so that its thickness is equal to, e.g., 100nm (2000 Å).

Then, as seen from FIG. 8E, the heat treatment process, the metallization process and the passivation process are implemented. In the above-mentioned heat treatment process, the N-type impurity in the polycrystalline silicon film 37 is diffused. A high concentration region 5a is thus formed.

As a mask in ion-implanting the N-type impurity, a nitride film may be used instead of the above-mentioned silicon oxide film and resist film.

As the N-type impurity, Sb may be used instead of the above-mentioned P and As.

While a Bi-Tr including NPN transistor has been described above, Bi-Tr including PNP transistor may be obtained in the same manner as stated above by allowing the conductivity to be opposite to the above. Another embodiment of the present invention is shown in FIG. 1C.

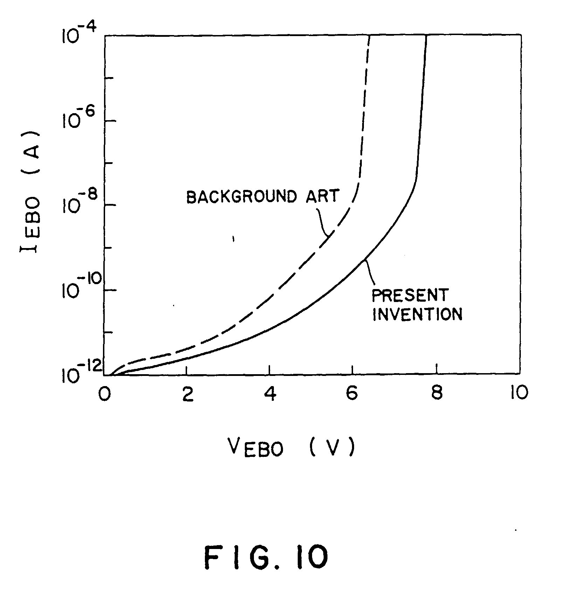

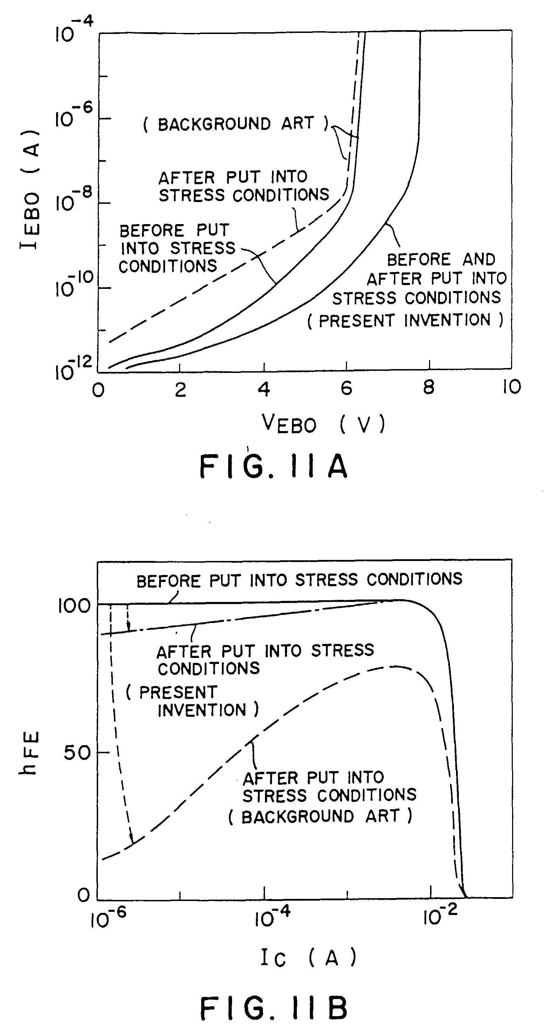

FIGS. 10 to 11b show the advantageous effects of the present invention. Especially, it will be understood from FIG. 11A that the emitter-base junction characteristics of the semiconductor device according to the present invention does not practically change even if the device is put into reverse bias stress conditions (V_{EBO} = 5V, 1000 sec), while the characteristics of the device according to the background art change widely. Furthermore, it will be understood from FIG. 11b that the current gain characteristics of the device according to the present invention changes only slightly if the device is put into the aforementioned conditions, while the characteristics of the device according to the background art changes greatly.

Reference signs in the claims are intended for better understanding and shall not limit the claims.

## Claims

1. A semiconductor device including a semiconductor substrate (1), and a bipolar transistor formed in said semiconductor substrate,
said bipolar transistor comprising:
a collector region (3) comprising a first conductivity type impurity;
a base region (4) comprising a second conductivity type impurity and formed in the vicinity of the surface of said collector region, and
an emitter region (5) comprising said first conductivity type impurity and formed in the vicinity of the surface of said base region,
said emitter region comprising a high concentration region (5a) having a high impurity concentration and a low concentration region (5b) having an impurity concentration considerably lower than that of said high concentration region, said high and low concentration regions being in columnar form, said columnar low concentration region having a lateral cross-section considerably larger than that of said high concentration region and a depth considerably smaller than that of said high concentration region, said high and low concentration regions being superimposed so that said low concentration region comprises a central columnar portion superimposed on a surface portion of said high concentration region and a peripheral annular portion surrounding said central columnar portion and said surface portion of said high concentration region,
whereby said emitter region essentially comprises high concentration impurities, the volume of said low concentration region being smaller than that of said high concentration impurity region.

2. A device as set forth in claim 1, wherein said high concentration region is formed as a quadrangular column, and said low concentration region is formed as a quadrangular frame.

3. A device as set forth in claim 1 or 2, wherein said semiconductor substrate is a substrate comprised of said second conductivity type impurity, and said collector region is a well region formed in said substrate.

4. A device as set forth in one of claims 1-3, wherein said first conductivity type impurity is an N-type impurity, and said second conductivity type impurity is a P-type impurity.

5. A device as set forth in one of claims 1-4, wherein said first conductivity type impurity is a P-type impurity, and said second conductivity type impurity is an N-type impurity.

6. A method of manufacturing a semiconductor device as set out in claims 1 - 5, having at least one bipolar transistor constructed by forming a second-conductivity type impurity base region on a surface of a first-conductivity type impurity collector region; and forming a bipolar transistor by forming a first-conductivity impurity emitter region on a surface of the base region, characterised by the following steps of:
forming a first mask layer (32,8) formed with a first aperture (32a,8a) in the surface of the base region;
ion-implanting first-conductivity type impurities (12) into the base region through the first aperture to form a low concentration region (5b) of the emitter;
forming a second mask layer (35) formed with a second aperture (35a) smaller than the first aperture on the surface of the low concentration region (5b) of the emitter;
depositing a diffusing film (35A) containing first-conductivity type impurities in the second aperture formed on the surface of the base region; and
diffusing by heat treatment the first-conductivity impurities from the diffusing film (35A) into the base region to form a high concentration region (5a) of the emitter.

7. The method of manufacturing a semiconductor device of claim 6, wherein the first mask layer (32,8) formed on a semiconductor substrate (1) is a first oxide film, the first aperture (32a, 8a) being formed by etching the first oxide film.

8. The method of manufacturing a semiconductor device of claim 6 or 7, wherein the second mask layer (34) is a second oxide film, the second aperture (35a) being formed by etching the second oxide film with a resist as a mask.

9. The method of manufacturing a semiconductor device of claim 6, 7 or 8, wherein the diffusion layer (35A) is a polycrystal silicon film formed by deposition.

10. A method as set forth in claim 6
which further comprises a step of introducing a first conductivity type impurity into a semiconductor substrate (1) comprised of a second conductivity type impurity thereafter to apply heat treatment thereto to form a first conductivity type buried layer (2) to form, by epitaxial growth, said collector region (3) of said first conductivity type on the surface of said buried layer (2).

11. A method as set forth in claim 6,
wherein said heat treatment process is implemented in a manner that heating is applied for 60 minutes in an atmosphere of N₂ at a temperature of 900°C.

12. A method as set forth in claim 6, wherein said process of introducing the impurity for forming said base region (4) is ion-implantation under the condition of 25 KeV, 5 x 10¹³ cm⁻², and wherein said process of introducing the impurity (12) for forming said low concentration emitter region (5b) is an ion-implantation under the condition of 20 KeV, 3 x 10¹³ cm-².

13. A method as set forth in claim 6, wherein said first opening (32a) is formed, using a resist (35) as a mask, by etching said first silicon oxide film (32) deposited by CVD process on an oxide film (8) forme on said base region (4) so that its thickness is equal to 100nm (1000 Å), and wherein said second opening (34a) is formed by removing said first silicon oxide film (32), thereafter to deposit another oxide film (34) with a thickness of 300nm (3000 Å) on said base region (4) by CVD process thereafter to etch said another oxide film (34) using said resist (35) as a mask.

## Patentansprüche

1. Halbleitereinrichtung mit einem Halbleitersubstrat (1) und einem Bipolartransistor, der in dem Halbleitersubstrat gebildet ist; wobei der Bipolartransistor umfaßt:
- einen Kollektorbereich (3), der eine Verunreinigung eines ersten Leitfähigkeitstyps umfaßt;
- einen Basisbereich (4), der eine Verunreinigung eines zweiten Leitfähigkeitstyps umfaßt und in der Nähe der Oberfläche des Kollektorbereichs gebildet ist; und
- einen Emitterbereich (5), der die Verunreinigung des ersten Leitfähigkeitstyps umfaßt und in der Nähe der Oberfläche des Basisbereichs gebildet ist;
- wobei der Emitterbereich einen Hochkonzentrations-Bereich (5a) mit einer hohen Verunreinigungskonzentration und einen Niedrigkonzentrations-Bereich (5b) mit einer Verunreinigungskonzentration, die wesentlich geringer als diejenige des Hochkonzentrations-Bereichs ist, umfaßt, wobei die Hoch- und Niedrigkonzentrations-Bereiche in säulenartiger Form sind, wobei der säulenartige Niedrigkonzentrations-Bereich einen lateralen Querschnitt, der wesentlich größer als derjenige des Hochkonzentrations-Bereichs ist, und eine tiefe, die wesentlich kleiner als diejenige des Hochkonzentrations-Bereichs ist, aufweist, wobei die Hoch- und Niedrigkonzentrations-Bereiche so überlagert sind, daß der Niedrigkonzentrations-Bereich einen zentralen säulenartigen Abschnitt, der auf den Oberflächenabschnitt des Hochkonzentrations-Bereichs überlagert ist, und einen ringförmigen Umfangsabschnitt, der den zentralen säulenartigen Abschnitt und den Oberflächenabschnitt des Hochkonzentrations-Bereichs umgibt, umfaßt,
- wodurch der Emitterbereich im wesentlichen Verunreinigungen mit hoher Konzentration umfaßt, wobei das Volumen des Niedrigkonzentrations-Bereichs kleiner als dasjenige des Hochkonzentrations-Verunreinigungs-Bereichs ist.

2. Einrichtung nach Anspruch 1, dadurch gekennzeichnet, daß der Hochkonzentrations-Bereich als eine viereckige Säule gebildet ist und der Niedrigkonzentrationsbereich als ein viereckiger Rahmen gebildet ist.

3. Einrichtung nach Anspruch 1 oder 2, dadurch gekennzeichnet, daß das Halbleitersubstrat ein Substrat ist, welches aus der Verunreinigung des zweiten Leitfähigkeitstyps besteht, und der Kollektorbereich ein Wannenbereich ist, der in dem Substrat gebildet ist.

4. Einrichtung nach einem der Ansprüche 1 - 3, dadurch gekennzeichnet, daß die Verunreinigung des ersten Leitfähigkeitstyps eine N-Typ Verunreinigung ist, und die Verunreinigung des zweiten Leitfähigkeitstyps eine P-Typ Verunreinigung ist.

5. Einrichtung nach einem der Ansprüche 1-4, dadurch gekennzeichnet, daß die Verunreinigung des ersten Leitfähigkeitstyps eine P-Typ Verunreinigung ist, und die Verunreinigung des zweiten Leitfähigkeitstyps eine N-Typ Verunreinigung ist.

6. Verfahren zum Herstellen einer Halbleitereinrichtung nach einem der Ansprüche 1 - 5, mit wenigstens einem Bipolartransistor, aufgebaut durch Bilden eines Basisbereichs mit einer Verunreinigung des zweiten Leitfähigkeitstyps auf einem Kollektorbereich mit einer Verunreinigung eines ersten Leitfähigkeitstyps; und Bilden eines Bipolartransistors durch Bilden eines Emitterbereichs mit einer Verunreinigung eines ersten Leitfähigkeitstyps auf einer Oberfläche des Basisbereichs, gekennzeichnet durch die folgenden Schritte:
- Bilden einer ersten Maskenschicht (32, 8), die mit einer ersten Öffnung (32a, 8a) ausgebildet ist, in der Oberfläche der Basisschicht;
- Ionenimplantieren von Verunreinigungen (12) des ersten Leitfähigkeitstyps in den Basisbereich hinein durch die erste Öffnung, um einen Bereich (5b) des Emitters mit niedriger Konzentration zu bilden;
- Bilden einer zweiten Maskenschicht (35), die mit einer zweiten Öffnung (35a), die kleiner als die erste Öffnung ist, ausgebildet ist, auf der Oberfläche des Bereichs (5b) des Emitters mit niedriger Konzentration;
- Aufbringen eines Diffusionsfilms (35A), der Verunreinigungen des ersten Leitfähigkeitstyps enthält, in die zweite Öffnung, die auf der Oberfläche des Basisbereichs gebildet ist; und
- Diffundieren der Verunreinigungen der ersten Leitfähigkeit von dem Diffusionsfilm (35A) in den Basisbereich hinein durch eine Wärmebehandlung, um einen Bereich (5a) des Emitters mit hoher Konzentration zu bilden.

7. Verfahren zum Herstellen einer Halbleitereinrichtung nach Anspruch 6, dadurch gekennzeichnet, daß die erste Maskenschicht (32, 8), die auf dem Halbleitersubstrat (1) gebildet ist, ein erster Oxidfilm ist, wobei die erste Öffnung (32a, 8a) durch Ätzen des ersten Oxidfilms gebildet wird.

8. Verfahren zum Herstellen einer Halbleitereinrichtung nach Anspruch 6 oder 7, dadurch gekennzeichnet, daß die zweite Maskenschicht (34) ein zweiter Oxidfilm ist, wobei die zweite Öffnung (35a) durch Ätzen des zweiten Oxidfilms mit einem Abdeckfilm als eine Maske gebildet wird.

9. Verfahren zum Herstellen einer Halbleitereinrichtung nach Anspruch 6, 7 oder 8, dadurch gekennzeichnet, daß die Diffusionsschicht (35A) ein polykristalliner Siliziumfilm ist, der durch Aufbringung gebildet ist.

10. Verfahren nach Anspruch 6, welches ferner den folgenden Schritt umfaßt: Einführen einer Verunreinigung eines ersten Leitfähigkeitstyps in ein Halbleitersubstrat (1) hinein, welches aus einer Verunreinigung eines zweiten Leitfähigkeitstyps aufgebaut ist, um danach eine Wärmebehandlung darauf anzuwenden, um eine vergrabene Schicht (2) des ersten Leitfähigkeitstyps zu bilden, um durch ein epitaktisches Aufwachsen den Kollektorbereich (3) des ersten Leitfähigkeitstyps auf der Oberfläche der vergrabenen Schicht (2) zu bilden.

11. Verfahren nach Anspruch 6, dadurch gekennzeichnet, daß der Wärmebehandlungsprozeß in einer Weise ausgeführt wird, daß eine Erwärmung für 60 Minuten in einer Atmosphäre von N₂ bei einer Temperatur von 900°C ausgeführt wird.

12. Verfahren nach Anspruch 6, dadurch gekennzeichnet, daß der Prozeß einer Einführung der Verunreinigung zum Bilden des Basisbereichs (4) eine Ionenimplantation unter der Bedingung von 25 KeV, 5 x 10¹³ cm⁻² ist, und der Prozeß eines Einführens der Verunreinigung (12) zum Bilden des Emitterbereichs (5b) mit niedriger Konzentration eine Ionenimplantation unter der Bedingung von 20 KeV, 3 x 10¹³ cm⁻² ist.

13. Verfahren nach Anspruch 6, dadurch gekennzeichnet, daß die erste Öffnung (32a) unter Verwendung eines Abdeckfilms (35) als eine Maske gebildet wird, durch Ätzen des ersten aufgebrachten Siliziumoxidfilms (32), der durch einen CVD-Prozeß auf einem Oxidfilm (8), der auf dem Basisbereich (4) gebildet ist, aufgebracht ist, so daß seine Dicke 100 nm (1000 Å) gleicht, und daß die zweite Öffnung (34a) durch Entfernen des ersten Siliziumoxidfilms (32) gebildet wird, um danach einen anderen Oxidfilm (34) mit einer Dicke von 300 nm (3000 Å) auf dem Basisbereich (4) durch einen CVD-Prozeß aufzubringen und um danach den anderen Oxidfilm (34) unter Verwendung des Abdeckfilms (35) als eine Maske zu ätzen.

## Revendications

1. Dispositif semiconducteur englobant un substrat de semiconducteur (1), et un transistor bipolaire formé dans ledit substrat de semiconducteur, ledit transistor bipolaire comprenant :
une zone de collecteur (3) comprenant une impureté de premier type de conductivité;
une zone de base (4) comprenant une impureté de second type de conductivité et formée au voisinage de la surface de ladite zone de collecteur, et
une zone d'émetteur (5) comprenant ladite impureté de premier type de conductivité et formée au voisinage de la surface de ladite zone de base,
ladite zone d'émetteur comprenant une zone de concentration élevée (5a) ayant une concentration d'impureté élevée et une zone de concentration faible (5b) ayant une concentration d'impureté considérablement plus faible que celle de ladite zone de concentration élevée, lesdites zones de concentrations élevées et faibles étant en forme de colonne, ladite zone de concentration faible en colonne ayant une coupe transversale considérablement plus importante que celle de ladite zone de concentration élevée et une profondeur considérablement plus petite que celle de ladite zone de concentration élevée, lesdites zones de concentrations élevées et faibles étant superposées de telle sorte que ladite zone de concentration faible comprend une portion centrale en colonne superposée sur une portion superficielle de ladite zone de concentration élevée et une portion annulaire périphérique entourant ladite portion centrale en colonne et ladite portion superficielle de ladite zone de concentration élevée,
et ainsi ladite zone d'émetteur comprend essentiellement des impuretés de concentration élevée, le volume de ladite zone de concentration faible étant plus petit que celui de ladite zone d'impureté de concentration élevée.

2. Dispositif selon la revendication 1, dans lequel ladite zone de concentration élevée est formée selon une colonne quadrangulaire, et ladite zone de concentration faible est formée selon un cadre quadrangulaire.

3. Dispositif selon la revendication 1 ou 2, dans lequel ledit substrat de semiconducteur est un substrat constitué de ladite impureté de second type de conductivité, et ladite zone de collecteur est une zone en puits formée dans ledit substrat.

4. Dispositif selon l'une quelconque des revendications 1 à 3, dans lequel ladite impureté de premier type de conductivité est une impureté de type N, et ladite impureté de second type de conductivité est une impureté de type P.

5. Dispositif selon l'une quelconque des revendications 1 à 4, dans lequel ladite impureté de premier type de conductivité est une impureté de type P, et ladite impureté de second type de conductivité est une impureté de type N.

6. Procédé de fabrication d'un dispositif semiconducteur selon les revendications 1-5, ayant au moins un transistor bipolaire construit en formant une zone de base d'impureté de second type de conductivité à la surface d'une zone de collecteur d'impureté de premier type de conductivité ; et en formant un transistor bipolaire en formant une zone d'émetteur d'impureté de première conductivité à la surface de la zone de base, caractérisé par les étapes suivantes de:
formation d'une première couche de masque (32, 8) formée avec une première ouverture (32a, 8a) dans la surface de la zone de base;
implantation ionique d'impuretés de premier type de conductivité (12) dans la zone de base à travers la première ouverture pour former une zone de faible concentration (5b) de l'émetteur;
formation d'une seconde couche de masque (35) formée avec une seconde ouverture (35a) plus petite que la première ouverture sur la surface de la zone de concentration faible (5b) de l'émetteur;
dépôt d'un film de diffusion (35A) contenant des impuretés de premier type de conductivité dans la seconde ouverture formée sur la surface de la zone de base; et
diffusion par traitement thermique des impuretés de première conductivité à partir du film de diffusion (35A) dans la zone de base pour former une zone de concentration élevée (5a) de l'émetteur.

7. Procédé de fabrication d'un dispositif semiconducteur selon la revendication 6, dans lequel la première couche de masque (32, 8) formée sur un substrat de semiconducteur (1) est un premier film d'oxyde , la première ouverture (32a, 8a) étant formée par attaque du premier film d'oxyde.

8. Procédé de fabrication d'un dispositif semiconducteur selon la revendication 6 ou 7, dans lequel la seconde couche de masque (34) est un second film d'oxyde , la seconde ouverture (35a) étant formée par attaque du second film d'oxyde avec une réserve comme masque.

9. Procédé de fabrication d'un dispositif semiconducteur selon l'une quelconque des revendications 6, 7 ou 8, dans lequel la couche de diffusion (35A) est un film de silicium polycristallin formé par dépôt.

10. Procédé selon la revendication 6, qui comprend en outre une étape qui consiste à introduire une impureté de premier type de conductivité dans un substrat de semiconducteur (1) constitué d'une impureté de second type de conductivité pour ensuite y appliquer un traitement thermique pour former une couche noyée (2) de premier type de conductivité pour former, par croissance épitaxiale, ladite zone de collecteur (3) dudit premier type de conductivité sur la surface de ladite couche noyée (2).

11. Procédé selon la revendication 6, dans lequel ledit procédé de traitement thermique est réalisé d'une manière telle que le chauffage est appliqué pendant 60 minutes dans une atmosphère de N₂ à une température de 900°C.

12. Procédé selon la revendication 6, dans lequel ledit procédé d'introduction de l'impureté pour former ladite zone de base (4) est une implantation ionique dans une condition correspondant à 25 KeV, 5 x 10¹³ cm⁻² et dans lequel ledit procédé d'introduction de l'impureté (12) pour former ladite zone d'émetteur (5b) de faible concentration est une implantation ionique dans une condition correspondant à 20KeV, 3 x 10¹³ cm⁻².

13. Procédé selon la revendication 6, dans lequel ladite première ouverture (32a) est formée, en utilisant une réserve (35) comme masque, par attaque dudit premier film d'oxyde de silicium (32) déposé par le procédé CVD sur un film d'oxyde (8) formé sur ladite zone de base (4) afin que son épaisseur soit égale à 100 nm (1000A), et dans lequel ladite seconde ouverture (34a) est formée en éliminant ledit premier film d'oxyde de silicium (32) , pour déposer ensuite un autre film d'oxyde (34) avec une épaisseur de 300 nm (3000 A) sur ladite zone de base (4) par le procédé CVD pour ensuite attaquer ledit autre film d'oxyde (34) en utilisant ladite réserve (35) comme masque.
